# EUROPEAN PATENT SPECIFICATION

(11) **EP 1 727 219 B1**
(45) Date of publication and mention of the grant of the patent: **07.05.2014**
(21) Application number: 05104440.2
(22) Date of filing: 25.05.2005
(51) Int. Cl.: H01L 51/00, H01L 51/05, H01L 27/00, H01L 51/40, H01L 51/10

(54) **Organic thin film transistor and method for producing the same**
Organischer Dünnschichttransistor und Verfahren zu seiner Herstellung
Transistor organique à couche mince et son procédé de fabrication

(43) Date of publication of application: 29.11.2006
(73) Proprietor: Samsung SDI Germany GmbH, 12459 Berlin (DE); Samsung Display Co., Ltd., Yongin-City, Gyeonggi-Do, 446-711 (KR)
(72) Inventor: Fischer, Joerg, 13053, Berlin (DE); Mathea, Arthur, 14197, Berlin (DE); Breithecker, Mario, 13053, Berlin (DE)
(74) Representative: Gulde & Partner

(56) References cited:
- EP-A2- 1 246 244
- US-A1- 2004 141 113
- US-B1- 6 403 392
- PLOTNER M ET AL: "Investigation of ink-jet printing of poly-3-octylthiophene for organic field-effect transistors from different solutions" SYNTHETIC METALS, ELSEVIER SEQUOIA, LAUSANNE, CH, vol. 147, no. 1-3, 7 December 2004 (2004-12-07), pages 299-303, XP004687513 ISSN: 0379-6779

## Description

### FIELD OF THE INVENTION

This invention relates to an Organic Thin Film Transistor (OTFT) and a method for producing the same. More specifically, this invention relates to a plurality of Organic Thin Film Transistors which are disposed on a substrate in a matrix-shape for an Active Matrix Display and a method for producing the same.

### BACKGROUND OF THE INVENTION

Organic Thin Film Transistors (OTFT) comprise an organic material between source electrode and drain electrode whereby the conductivity of the organic material (channel) is controlled by the gate electrode of the OTFT.

In several applications, e.g. in an Active Matrix Display a plurality of OTFT's are arranged in a matrix vertical and horizontal lines thereby forming a matrix.
In manufacturing processes of OTFT's (arranged in a matrix) the OTFT's are structured by a method of depositing an array of semiconductor areas (as channels) which overlap the drain and source electrodes. The organic semiconductor material will be deposited onto the OTFT substrate (already comprising drain and source electrodes) by using thermal evaporation of organic semiconductor materials through a shadow mask or by using solution based processes for semiconductor materials - printing techniques such as Inkjet printing or Flexo printing or doctor blade coating or other technologies.

The patterning of the semiconductor layer is essential to achieve a good single transistor performance such as high ON/OFF current ratio. The patterning is also required to prevent unwanted cross talk effects between adjacent TFTs and conductive lines in an electronic circuit. The non patterned semiconductor material can cause a current leakage path. Therefore the semiconductor material has to be deposited only in the channel area of a single transistor whereby no contact to the channel area of adjacent TFTs shall occur.

WO 03/098696 A1 (Seiko Epson) describes the fabrication of circuit interconnections in thin film circuits, involving the use of lithographic technique to provide patterned layer and depositing first material at localized regions using inkjet printing technique.

EP 1 139 455 A2 (Seiko Epson) describes a method of manufacturing an organic EL (electroluminescent) element. A special patterning is required to have an opening corresponding to the region for the formation of an constitutive layer.

US 2003/0059975 A1 and WO 01/46987 A2 (Plastic Logic) describe a method of forming at least one part of an integrated circuit by ink-jet printing.

WO 03/056641 A1 (Plastic Logic) describes a method for forming an organic or partly organic switching device, comprising: depositing layers of conducting, semi conducting and/or insulating layers by solution processing and direct printing; defining high-resolution patterns of electro-active polymers by self-aligned formation of a surface energy barrier around a first pattern that repels the solution of a second material.

DE 100 61 297 A1 (Siemens) describes an organic field-effect transistor (OFET), a method for structuring an OFET and an integrated circuit with improved structuring of the functional polymer layers. The improved structuring is obtained by introducing, using a doctor blade, the functional polymer in the mold layer into which recesses are initially produced by an additional step like imprinting.

US 5,946,551 (Dimitrakopoulos et al.) describes the fabrication of TFTs with organic semiconductor. Shadow mask techniques are used to define source/drain metal electrodes.

US 6,667,215 B2 (3M) describes a method for the manufacture of transistors. Stationary shadow masks are used to define source/drain electrodes.

US 6,384,529 B2 (Kodak) describes an color active matrix organic electroluminescent display having an integrated shadow mask. The shadow masks are used to define the color conversion layers or the emissive RGB sub pixels.

US 5,742,129 (Pioneer) describes a method for manufacturing an organic EL display panel having a plurality of emitting portions surrounded by ramparts and arranged as a matrix. In the method, the shadow mask is used to deposit the media. There is always a repeated putting and aligning step required to deposit the media through the openings of the shadow mask.

EP 1 246 244 A2 (Pioneer) deals with easing manufacturing of an organic electroluminescence unit.

However, all techniques for the deposition of the semiconductor known from the state of the art require a very precise alignment procedure. In case of shadow mask technique a very precise alignment between shadow mask and substrate is required. In case of photolithographic patterned semiconductor, the photomask has to be precisely aligned as well. All printing techniques for the deposition of the semiconductor known from the state of the art require a very precise alignment procedure between printing device and substrate (to be printed). Especially printing processes for flexible substrates require cost intensive local registration during said printing process due to a possible shrinkage of the substrate.

### OBJECTS OF THE INVENTION

Therefore one object of the invention is to provide a substrate having a plurality of Organic Thin Film Transistors which requires more simple manufacturing techniques in comparison to organic TFT devices of the state of the art. Another object of the invention is to provide a method for producing Organic Thin Film Transistors, especially a plurality of Organic Thin Film Transistors arranged on a substrate in a matrix or in a circuit which requires lower costs. A further object of the invention is to provide an apparatus capable to produce a plurality of Organic Thin Film Transistors arranged on a substrate at a lower price.

### SUMMARY OF THE INVENTION

In one aspect of the invention a substrate having a plurality of thin film transistors, each transistor comprising a drain electrode, a source electrode and a channel of semiconducting material connecting drain electrode and source electrode is provided, whereby the minimal distance between drain electrode and source electrode of one transistor is smaller than the minimal distance between electrodes of adjacent transistors or between electrodes and other conductive lines of the substrate, whereby the channel of semiconducting material of the thin film transistors is formed by a regular pattern of semiconducting elements of semiconducting material where the maximal dimension of the semiconducting elements of the pattern is smaller than the minimal distance between electrodes of adjacent pairs (or between electrodes and other conductive lines of the substrate) but at least equal to the minimal distance between drain electrode and source electrode of one pair.

In another aspect of the invention a substrate comprising a plurality of pairs of drain electrodes and source electrodes for thin film transistors is provided whereby the minimal distance between drain electrode and source electrode of one pair is smaller than the minimal distance between electrodes of adjacent pairs or between electrodes and other conductive lines of the substrate, whereby the substrate comprises a regular pattern of semiconducting elements of semiconducting material, for each of the pairs, some semiconducting elements connecting the drain electrode and source electrode of the pair, for each of the pairs, some semiconducting elements connecting the drain electrode and source electrode of the pair, other semiconducting elements contacting only one of the drain electrode and the source electrode of the pair, where the maximal dimension of the semiconducting elements of the pattern is smaller than the minimal distance between electrodes of adjacent pairs or between electrodes and other conductive lines of the substrate, but at least equal to the minimal distance between drain electrode and source electrode of one pair.

Preferably the substrate comprises a rectangular shape and the drain electrodes and source electrodes comprise a longish shape where the longitudinal axes of

drain electrode and source electrode of one pair are disposed parallel to each other and parallel to one of the edges of the rectangular-shaped substrate.

Preferably the maximal dimension of the semiconducting elements of the pattern is at least 50% bigger than the minimal distance between drain electrode and source electrode of one pair. In a very preferred embodiment of the invention the maximal dimension of the semiconducting elements of the pattern is 100% bigger than the minimal distance between drain electrode and source electrode of one pair.

Preferably the minimal distance between electrodes of adjacent pairs is at least 200% bigger than the minimal distance between drain electrode and source electrode of one pair.

By the application of a regular pattern of semiconducting material it is possible to form the semiconducting channels of a plurality of TFT's without the necessity of precise alignment of the used technique because by the above-described dimensions the pattern elements (of semiconducting material) and the distances between source electrode and drain electrode of one pairs (or TFT) and adjacent electrodes (or other conductive lines on the substrate) there will always be a semiconducting material in all horizontal and vertical lines of the substrate connecting the pairs of electrodes thereby forming an TFT (or preliminary product). Therefore the substrate having a plurality of TFT's can be manufactured without precise alignment requirements which require complex technology and process time.

The alignment requirements are only such that the pattern has to be applied in the substrate region, e.g. accuracy in the range of several mm or cm, whereby the alignment requirements according to the state of the art are in the sub-mm range, e.g. in the µm range.

Preferably the semiconducting elements of the pattern are circular shaped. In a very preferred embodiment of the invention the semiconducting elements of the pattern are arranged in a hexagon shape to each other. The advantage of circular-shaped semiconducting elements of the pattern is that simple drops can be applied which can be carried out with low-cost shadow mask processes or printing processes. Furthermore the hexagon-shape arrangement of the elements of the pattern is advantageous because this leads to a very homogeneous distribution of pattern elements for all horizontal and vertical lines of the substrate (which comprise the electrodes and the channels between the electrodes).

In a preferred embodiment of the invention the hexagons of the pattern are tilted by 15° in respect to the longitudinal axes of drain electrodes and source electrodes because such an arrangement results in a superior homogeneous distribution of pattern elements for all horizontal and vertical lines of the substrate. A superior homogeneity for horizontal and vertical lines of the substrate can be required for the case in which the plurality of thin film transistors are arranged such that there exist two possible directions for the longitudinal axes of the electrodes which are perpendicular to each other.

According to the invention a method for producing a substrate comprising a plurality of thin film transistors, each transistor comprising a drain electrode, a source electrode, a gate electrode and a channel of semiconducting material connecting drain electrode and source electrode is provided, comprising the step of forming a plurality a pairs of drain electrodes and source electrodes on the substrate whereby the minimal distance between drain electrode and source electrode of one pair is smaller than the minimal distance between electrodes of adjacent pairs or between electrodes and other conductive lines of the substrate and wherein the channel of semiconducting material of the plurality of thin film transistors is formed by applying a regular pattern of semiconducting elements of semiconducting material where the maximal dimension of the semiconducting elements of the pattern is smaller than the minimal distance between electrodes of adjacent pairs but at least equal to the minimal distance between drain electrode and source electrode of one pair. This method for forming the semiconducting channels for a plurality of TFT's requires lower alignment demands and can be therefore carried out faster and at lower costs. The main idea of the invention is to form the semiconducting channels by a pattern having such dimensions that in all horizontal and vertical lines of the substrate (which comprise the electrodes and the channels between the electrodes) always sufficient semiconducting material is applied thereby sufficiently connecting all pairs of electrodes of the plurality of TFT's.

Preferably the channels of semiconducting material of the plurality of thin film transistors are formed by applying a hexagon-shaped pattern wherein the semiconducting elements of the pattern are circular shaped.

In a first preferred embodiment the application of the pattern is carried out by deposition of semiconducting material by thermal evaporation through a shadow mask. Preferably a shadow mask is used which comprises a hexagon-shaped pattern and the shadow mask is arranged such that the hexagons of the shadow mask are tilted by 15° in respect to the longitudinal axes of drain electrodes and source electrodes. Furthermore the invention provides a shadow mask for the application of semiconducting material for a plurality of thin film transistors, whereby the shadow mask comprises hexagon-shaped pattern and the shadow mask furthermore comprises a rectangular shape where the hexagons of the pattern of the shadow mask are tilted by 15° in respect to one of the edges of the shadow mask.

In a second preferred embodiment the application of the pattern is carried out by printing techniques, preferably inkjet printing techniques. Preferably a print pattern is used which comprises a hexagon-shaped pattern and the print pattern is arranged such that the hexagons of the pattern are tilted by 15° in respect to the longitudinal axes of drain electrodes and source electrodes. Furthermore the invention provides a print pattern for the application of semiconducting material for a plurality of thin film transistors, whereby the print pattern comprises hexagon-shaped pattern. Preferably the print pattern comprises a rectangular shape where the hexagons of the pattern of the pattern are tilted by 15° in respect to one of the edges of the hole print pattern.

### BRIEF DESCRIPTION OF THE DRAWINGS

The present invention will now be described by way of example with reference to the accompanying drawings, in which:
- Fig. 1: shows a bottom gate Organic Thin Film Transistor in a sectional view,
- Fig. 2: shows a top gate Organic Thin Film Transistor in a sectional view,
- Fig. 3 a): shows the basic principle of the deposition of organic semiconductor material through a shadow mask for the manufacture of a bottom gate Organic Thin Film Transistor in a sectional view,

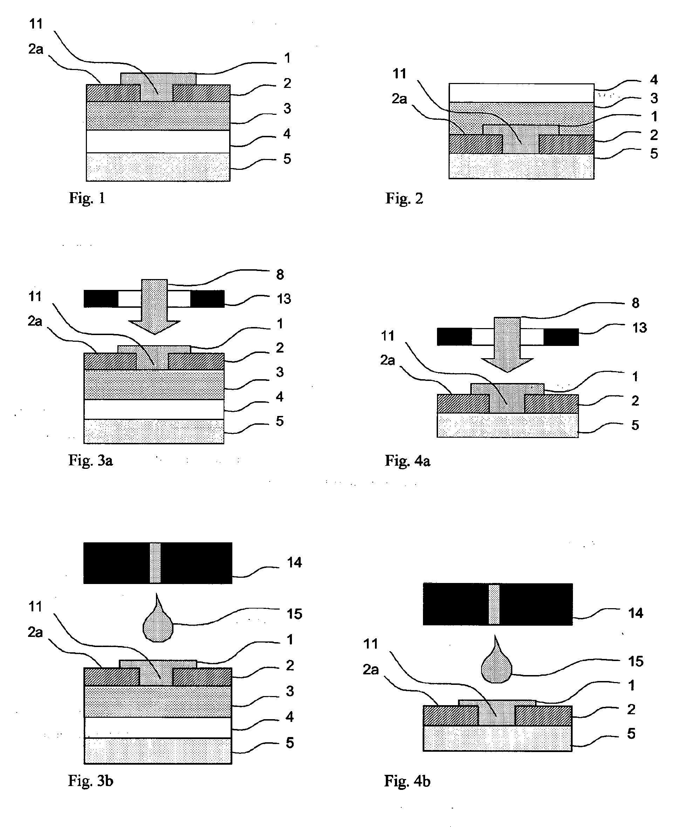

- Fig. 3 b): shows the basic principle of the deposition of organic semiconductor material by inkjet printing for the manufacture of a bottom gate Organic Thin Film Transistor in a sectional view, of a bottom gate Organic Thin Film Transistor in a sectional view,
- Fig. 4 a): shows the basic principle of the deposition of organic semiconductor material through a shadow mask for the manufacture of a top gate Organic Thin Film Transistor in a sectional view,
- Fig. 4 b): shows the basic principle of the deposition of organic semiconductor material by inkjet printing for the manufacture of a top gate Organic Thin Film Transistor in a sectional view,

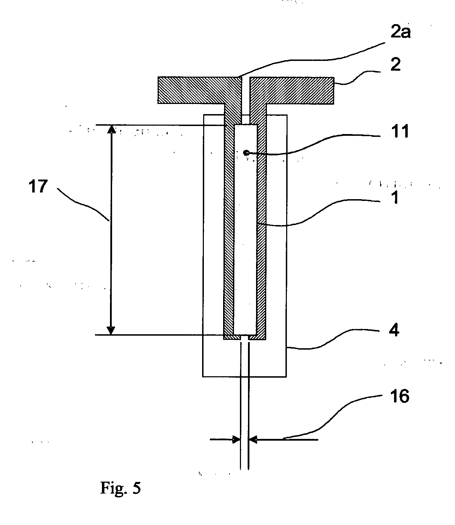

- Fig. 5: shows a top view of a conventional organic TFT architecture with patterned semiconductor,

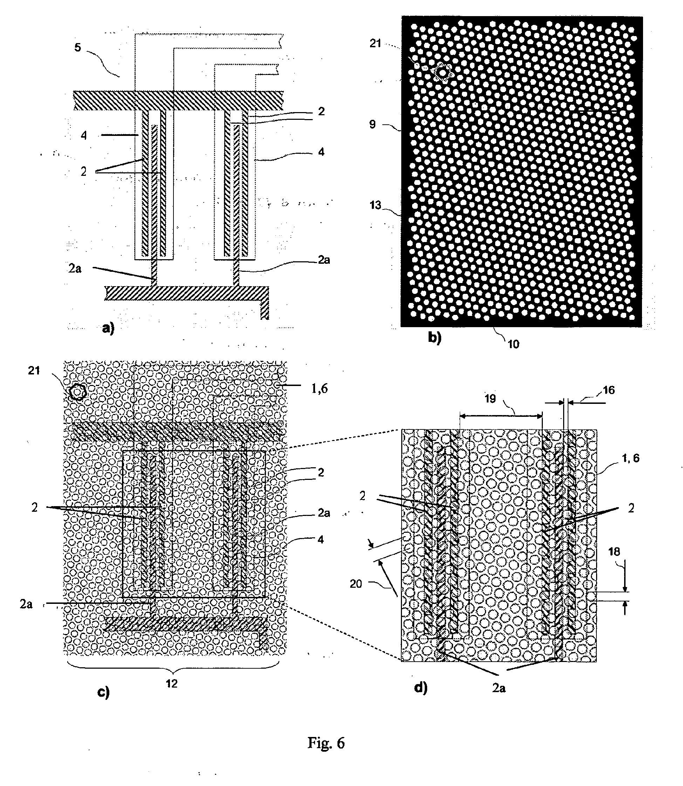

- Fig. 6 a): shows a top view of a section of a substrate comprising a plurality of TFT's having source, drain and gate electrode prior to the application of the semiconducting material (channel),
- Fig. 6 b): shows the shadow mask used for the application of the semiconducting material (channel) according to the invention,
- Fig. 6 c): shows a top view of a section of a substrate comprising a plurality of TFT's having source, drain and gate electrode after the application of the semiconducting material (channel),
- Fig. 6 d): shows an enlarged view of a section of Fig. 6 c),

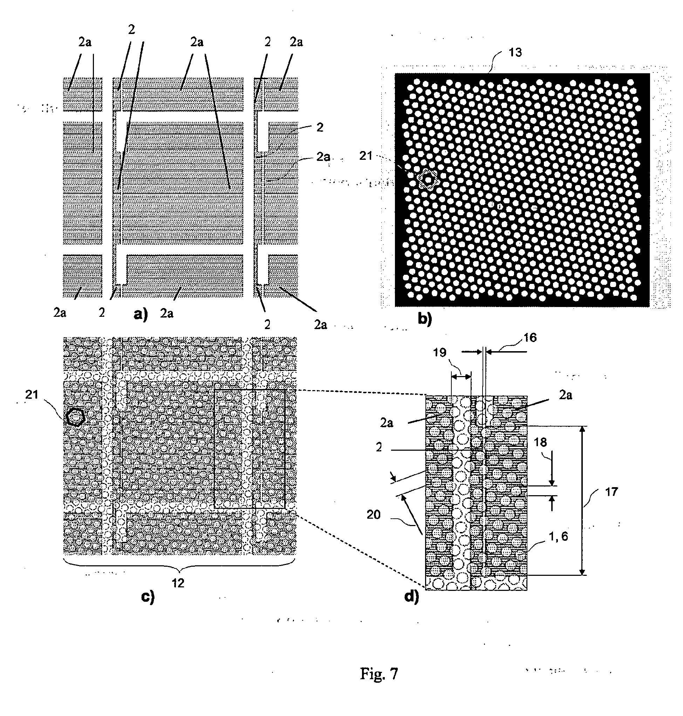

- Fig. 7 a): shows a top view of a section of a substrate comprising a plurality of TFT's having source, drain and gate electrode prior to the application of the semiconducting material (channel),
- Fig. 7 b): shows a top view the shadow mask used for the application of the semiconducting material (channel) according to the invention,
- Fig. 7 c): shows a top view of a section of a substrate comprising a plurality of TFT's having source, drain and gate electrode after the application of the semiconducting material (channel),
- Fig. 7 d): shows an enlarged view of a section of Fig. 7 c),

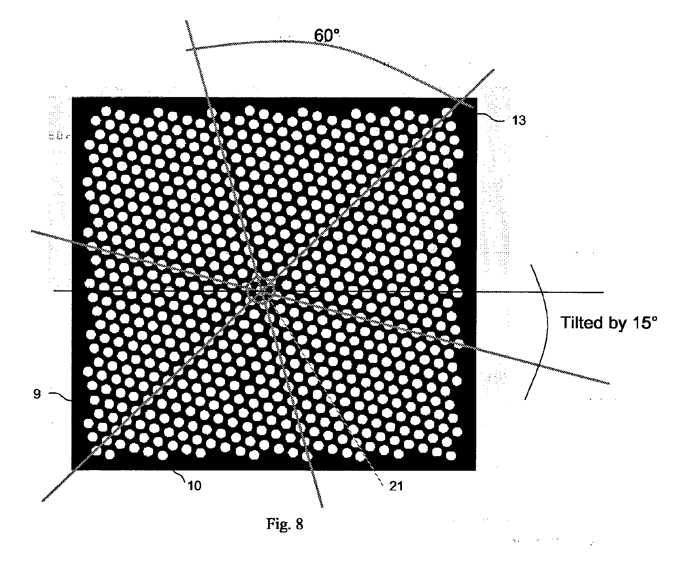

- Fig. 8: shows a top view the shadow mask used for the application of the semiconducting material (channel) according to the invention, and

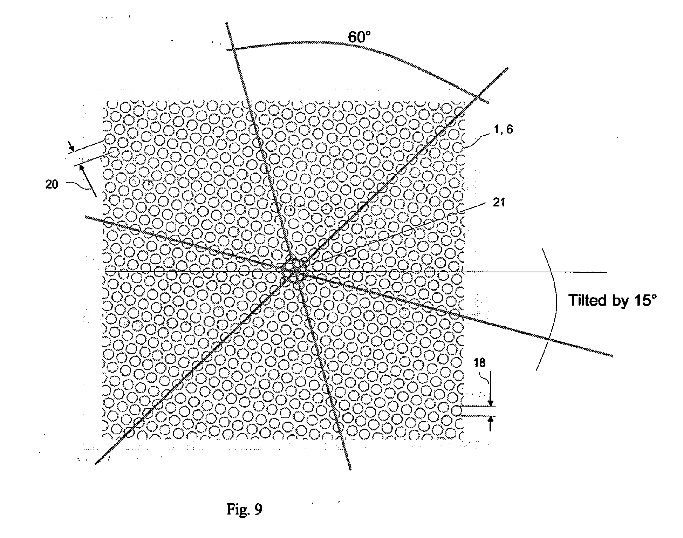

- Fig. 9: shows a top view the pattern applied during the manufacture of a TFT's according to the invention.

### DETAILED DESCRIPTION OF PREFERRED EMBODIMENTS

Fig. 1 shows a bottom gate Organic Thin Film Transistor in a sectional view which can be used for example for active matrix OLED. The Organic Thin Film Transistor comprises a gate electrode 4 (which is disposed on a (ground) substrate 5), an insulator 3, a source electrode 2 and a drain electrode 2a, whereby semiconducting material 1 is disposed between source electrode 2 and drain electrode 2a thereby forming the semiconducting channel 11.

Fig. 2 shows a top gate Organic Thin Film Transistor in a sectional view which can be used for example for active matrix OLED. The Organic Thin Film Transistor comprises a source electrode 2 and a drain electrode 2a (which are disposed on a (ground) substrate 5), whereby semiconducting material 1 is disposed between source electrode 2 and drain electrode 2a thereby forming the semiconducting channel 11. An insulator 3 and a gate electrode 4 are disposed upon the electrodes 2, 2a and the channel 11.

Fig. 3 a) and Fig. 4 a) show the basic principle of the deposition of organic semiconductor material 1 through a shadow mask 13 for the manufacture of a bottom (Fig. 3a) or a top (Fig. 4a) gate Organic Thin Film Transistor in a sectional view. The evaporation stream 8 is controlled by the openings of the shadow mask 13 thereby resulting in a deposition of semiconductor material 1 at certain areas (between source electrode 2 and drain electrode 2a). A continuous deposition of semiconductor material 1 is not possible because connections between adjacent TFT's have to be avoided. Therefore high alignment requirements for the shadow mask 13 in relation to the substrate 5 exist in order to deposit the semiconductor material 1 (more or less exactly) between source electrode 2 and drain electrode 2a.

Fig. 3 b) and Fig. 4 b) show the basic principle of the deposition of organic semiconductor material 1 by inkjet printing for the manufacture of a bottom (Fig. 3b) or a top (Fig. 4b) gate Organic Thin Film Transistor in a sectional view. The application of semiconductor ink droplets 15 is controlled by the print head 14 thereby resulting in a deposition of semiconductor material 1 at certain areas (between source electrode 2 and drain electrode 2a). A continuous deposition of semiconductor material 1 is not possible because connections between adjacent TFT's have to be avoided. Therefore high alignment requirements for the print head 14 in relation to the substrate 5 exist in order to deposit the semiconductor material 1 (more or less exactly) between source electrode 2 and drain electrode 2a.

Fig. 5 shows a top view of a conventional organic TFT architecture (=state of the art) comprising source electrode 2, drain electrode 2a and semiconductor channel 11 connecting source electrode 2 and drain electrode 2a. The openings of the shadow mask (not shown) have to be precisely positioned over the gaps between source electrodes 2 and drain electrodes 2a for the deposition of the semiconductor material 1. The precision is usually in the sub-mm range, for active matrix OLED with high resolution in the µm range. The channel 11 to be filled with semiconductor material 1 comprises a channel Length 16 (L) of the transistor (distance between drain and source electrode) and a channel Width 17 (W) of the transistor.

Fig. 6 a) shows a top view of a section of a substrate 5 comprising two TFT's having source, drain and gate electrode 2, 2a, 4 prior to the application of the semiconducting material 1 (channel 11). The minimal distance 16 between drain electrode 2a and source electrode 2 of one pair is smaller than the minimal distance 19 between electrodes 2, 2a of adjacent pairs or between electrodes 2, 2a and other conductive lines (not shown) of the substrate 5, see also Fig. 6 d). The manufacture of the preliminary product of Fig. 6a) is known as state of the art.
Fig. 6 b) shows the shadow mask 13 used for the application of the semiconducting material 1 (channel 11). The shadow mask 13 comprises a hexagon-shaped pattern 12 and edges 9, 10 wherein the hexagons 21 are tilted by 15° in respect to the longitudinal axis of edge 10 (more precisely shown in Fig. 8).

Fig. 6 c) shows a top view of a section of a substrate 5 comprising two TFT's having source, drain and gate electrode 2, 2a, 4 after the application (deposition) of the semiconducting material 1 (channel 11). The substrate 5 now comprises a plurality circular shaped patterned semiconductor areas 6 which result in the pattern 12. The diameter 18 of the regularly applied semiconducting elements 6 consisting of semiconducting material 1 is larger than the distance 16 between drain electrode 2a and source electrode 2 of each of the two TFT. Due to the afore-mentioned conditions there always exist semiconducting elements 6 (circular shaped) of pattern 12 which connect drain electrode 2a and source electrode 2 of each TFT. The pattern 12 is more precisely shown in Fig. 9. It shall be obvious that such a deposition results in a non continuous channel 11 between drain electrode 2a and source electrode 2. But the deposition of semiconducting material 1 is sufficient for the operation of said TFT's. Alternatively the pattern 12 can be applied by ink jet printing (instead of using the shadow mask 13).

The main advantage is that a precise alignment of shadow mask 13 or the print head in relation to the substrate 5 (i.e. in relation to the electrodes 2, 2a of the TFT's) can be avoided. Due to the aforementioned dimensions of 18 and 19 (the distance 19 is larger than 18) there is no unwanted connection between adjacent TFT electrodes or other conductive lines (not shown) via semiconducting material
1. But in the channel region 11 there is sufficient semiconductor material 1 between source and drain electrodes 2, 2a in approx. 50% of the channel width 17. Even though the mask 13 will be shifted by a small distance, there will be a similar result.
   In case the deposition of the semiconductor material 1 is carried out by ink jet printing the advantage is, that a precise alignment of the print head 14 in relation to the substrate 5 can be avoided. Especially printing processes for flexible substrates do not longer require cost intensive local registration during said printing process due to a possible shrinkage of the substrate.

Fig. 7 a) shows a top view of a section of a substrate 5 comprising several source electrodes 2, drain electrodes 2a and gate electrodes 4 prior to the application of the semiconducting material 1 (channel 11), the gate electrodes not shown being located in the area (channel) between respective pairs of source electrodes 2 and drain electrodes 2a. The semiconductor layer for the channel is patterned using new shadow mask 13 design without the need of precise alignment. As it can be seen in Fig. 7 c) there are many circular shaped patterned semiconductor areas 6 forming the pattern 12 in the final OTFT circuit. There is no unwanted connection path to a neighbour TFT electrodes 2, 2a or other conductive lines because the distance 19 is larger than the dimension 18, see Fig. 7-d). But in the channel region (channel has the length 16 between electrode 2 and 2a and the width 17) there is sufficient semiconductor material 1 between source 2 and drain 2a electrodes. Approx. 50% of the channel is filled with semiconductor material 1. There is no need to use a cost intensive, complicated mask alignment to fabricate OTFT circuits. This new TFT device structure would enable easier fabrication on glass or plastic substrates and the use of such devices in flat panel display applications or other electronic circuits such as RFID tags or sensors. Top and bottom gate architectures are possible. The application of the semiconductor material 1 results in a bottom structure. In case of a top gate TFT structure the gate electrodes 4 are deposited after the deposition of semiconducting material 1 and the insulator 3. Alternatively the pattern 12 can be applied by ink jet printing (instead of using the shadow mask 13).

As can be seen from Figs. 6 d) and 7 d) the center-to-center distance 20 (N) of neighbouring semiconductor elements 6 is preferably larger than the maximal dimension 18 (D) of the semiconducting elements. Furthermore the channel width 17 (W) of the thin film transistor is preferably larger than the center-to-center distance 20 (N) of neighbouring semiconductor elements 6.

### List of Reference Signs

- 1: Semiconducting Material
- 2: Source Electrode
- 2a: Drain Electrode
- 3: Insulator
- 4: Gate Electrode
- 5: Substrate
- 6: Semiconducting Elements of Pattern
- 7: Longitudinal Axis
- 8: Evaporation Stream
- 9: Edge of Shadow Mask
- 10: Edge of Shadow Mask
- 11: Channel
- 12: Circular Shaped Pattern of Semiconducting Material
- 13: Shadow Mask
- 14: Print Head
- 15: Semiconductor Ink droplet
- 16: Channel Length (L) of the transistor (distance between drain and source electrode)
- 17: Channel Width (W) of the transistor
- 18: Dimension (D) of the semiconducting elements of the pattern
- 19: Distance (M) between transistor electrodes of adjacent pairs or between electrodes and other conductive lines
- 20: Center-to-center distance (N) of neighbouring semiconductor elements
- 21: Hexagon

## Claims

1. Substrate (5) comprising a plurality of pairs of drain electrodes (2a) and source electrodes (2) for organic thin film transistors whereby the minimal distance (L) between drain electrode (2a) and source electrode (2) of one pair is smaller than the minimal distance (M) between electrodes (2, 2a) of adjacent pairs or between electrodes (2, 2a) and other conductive lines of the substrate (5),
**wherein**
the substrate (5) comprises a regular pattern (12) of semiconducting elements (6) of semiconducting material (1), for each of the pairs, some semiconducting elements (6) connecting the drain electrode (2a) and source electrode (2) of the pair, other semiconducting elements contacting only one of the drain electrode (2a) and the source electrode (2) of the pair,
where the maximal dimension (D) of the semiconducting elements (6) of the pattern (12) is smaller than the minimal distance (M) between electrodes (2, 2a) of adjacent pairs but at least equal to the minimal distance (L) between drain electrode (2a) and source electrode (2) of one pair.

2. Substrate (5) comprising a plurality of organic thin film transistors, each transistor comprising a drain electrode (2a), a source electrode (2), a gate electrode (4) and a channel (11) of semiconducting material (1) connecting drain electrode (2a) and source electrode (2) whereby the minimal distance (L) between drain electrode (2a) and source electrode (2) of one transistor is smaller than the minimal distance (M) between electrodes (2, 2a) of adjacent transistors or between electrodes (2, 2a) and other conductive lines of the substrate,
**wherein**
the channel (11) of semiconducting material (1) of the thin film transistors is formed by a regular pattern (12) of semiconducting elements (6) of semiconducting material (1) where the maximal dimension (D) of the semiconducting elements (6) of the pattern (12) is smaller than the minimal distance (M) between electrodes (2, 2a) of adjacent pairs but at least equal to the minimal distance (L) between drain electrode (2a) and source electrode (2) of one pair.

3. Substrate according to Claim 1, or 2, **wherein** the drain electrodes (2a) and source electrodes (2) comprise a longish shape where the longitudinal axes (7) of drain electrode (2a) and source electrode (2) of one pair are disposed parallel to each other.

4. Substrate according to one of the preceding claims, **wherein** the maximal dimension (D) of the semiconducting elements (6) of the pattern (12) is at least 50% bigger than the minimal distance (L) between drain electrode (2a) and source electrode (2) of one pair.

5. Substrate according to one of the preceding claims, **wherein** the maximal dimension (D) of the semiconducting elements (6) of the pattern (12) is at least 100% bigger than the minimal distance (L) between drain electrode (2a) and source electrode (2) of one pair.

6. Substrate according to one of the preceding claims, **wherein** the minimal distance (M) between electrodes (2, 2a) of adjacent pairs is at least 200% bigger than the minimal distance (L) between drain electrodes (2a) and source electrode (2) of one pair.

7. Substrate according to one of the preceding claims, **wherein** the semiconducting elements (6) of the pattern (12) are circular shaped.

8. Substrate according to one of the preceding claims, **wherein** the semiconducting elements (6) of the pattern (12) are arranged in a hexagon shape.

9. Substrate according to claim 8, **wherein**
the hexagons (21) of the pattern (12) are tilted by 15° in respect to the longitudinal axes (7) of drain electrodes (2a) and source electrodes (2).

10. Method for producing a substrate (5) comprising a plurality of organic thin film transistors, each transistor comprising a drain electrode (2a), a source electrode (2), a gate electrode (4) and a channel (11) of semiconducting material (1) connecting drain electrode (2a) and source electrode (2),
comprising the steps of forming a plurality of pairs of drain electrodes (2a) and source electrodes (2) on the substrate (5) whereby the minimal distance (L) between drain electrode (2a) and source electrode (2) of one pair is smaller than the minimal distance (M) between electrodes (2, 2a) of adjacent pairs or between electrodes (2, 2a) and other conductive lines of the substrate (5),
**wherein**
the channel (11) of semiconducting material (1) of the plurality of thin film transistors is formed by applying a regular pattern (12) of semiconducting elements (6) of semiconducting material (1) where the maximal dimension (D) of the semiconducting elements (6) of the pattern (12) is smaller than the minimal distance (M) between electrodes (2, 2a) of adjacent pairs but at least equal to the minimal distance (M) between drain electrode (2a) and source electrode (2) of one pair.

11. Method according to claim 10, **wherein**
the channels of semiconducting material (1) of the plurality of thin film transistors are formed by applying a hexagon-shaped pattern (12) wherein the semiconducting elements (6) of the pattern (12) are circular shaped.

12. Method according to claims 10 or 11, **wherein**
the application of the pattern (12) is carried out by deposition of semiconducting material (1) through a shadow mask (13).

13. Method according to claim 12, **wherein**
the shadow mask (13) having a hexagon-shaped pattern (12) is used and arranged such that the hexagons (21) of the shadow mask (13) are tilted by 15° in respect to the longitudinal axes (7) of drain electrodes (2a) and source electrodes (2).

14. Method according to claims 10 or 11, **wherein**
the application of the pattern (12) is carried out by deposition of semiconducting material (1) with printing a pattern of droplets without alignment procedure or local registration.

15. Method according to claim 14, **wherein**
ink jet printing is used for printing the pattern of droplets and a hexagon-shaped pattern (12) is applied and arranged such that the hexagons (21) of the pattern (12) are tilted by 15° in respect to the longitudinal axes (7) of drain electrodes (2a) and source electrodes (2).

16. Shadow mask (13) for the application of semiconducting material (1) according to the method of one of claims 10 to 15 for a plurality of organic thin film transistors, the shadow mask (13) comprising hexagon-shaped pattern (12)
**wherein**
the shadow mask (13) comprises a rectangular shape where the hexagons (21) of the pattern (12) of the shadow mask (13) are tilted by 15° in respect to one of the edges (9, 10) of the shadow mask (13).

## Patentansprüche

1. Substrat (5), aufweisend eine Vielzahl von Paaren von Drain-Elektroden (2a) und Source-Elektroden (2) für organische Dünnschichttransistoren, wobei der kleinste Abstand (L) zwischen der Drain-Elektrode (2a) und der Source-Elektrode (2) eines Paars kleiner als der kleinste Abstand (M) zwischen Elektroden (2, 2a) benachbarter Paare oder zwischen Elektroden (2, 2a) und anderen leitenden Leitungen des Substrats (5) ist,
wobei
das Substrat (5) ein regelmäßiges Muster (12) von Halbleiterelementen (6) aus Halbleitermaterial (1) für jedes der Paare aufweist, wobei einige Halbleiterelemente (6) die Drain-Elektrode (2a) und die Source-Elektrode (2) des Paars verbinden, wobei andere Halbleiterelemente nur mit einer der Drain-Elektrode (2a) und der Source-Elektrode (2) des Paars in Kontakt stehen, wobei die größte Größe (D) der Halbleiterelemente (6) des Musters (12) kleiner als der kleinste Abstand (M) zwischen Elektroden (2, 2a) benachbarter Paare, doch zumindest gleich dem kleinsten Abstand (L) zwischen der Drain-Elektrode (2a) und der Source-Elektrode (2) eines Paars ist.

2. Substrat (5), aufweisend eine Vielzahl organischer Dünnschichttransistoren, wobei jeder Transistor eine Drain-Elektrode (2a), eine Source-Elektrode (2), eine Gate-Elektrode (4) und einen Kanal (11) aus Halbleitermaterial (1), der die Drain-Elektrode (2a) und die Source-Elektrode (2) verbindet, aufweist, wobei der kleinste Abstand (L) zwischen der Drain-Elektrode (2a) und der Source-Elektrode (2) eines Transistors kleiner als der kleinste Abstand (M) zwischen Elektroden (2, 2a) benachbarter Transistoren oder zwischen Elektroden (2, 2a) und anderen leitenden Leitungen des Substrats (5) ist,
wobei
der Kanal (11) aus Halbleitermaterial (1) der Dünnschichttransistoren durch ein regelmäßiges Muster (12) von Halbeleiterelementen (6) aus Halbleitermaterial (1) ausgebildet ist, wobei die größte Größe (D) der Halbleiterelemente (6) des Musters (12) kleiner als der kleinste Abstand (M) zwischen Elektroden (2, 2a) benachbarter Paare, jedoch zumindest gleich dem kleinsten Abstand (L) zwischen der Drain-Elektrode (2a) und der Source-Elektrode (2) eines Paars ist.

3. Substrat nach Anspruch 1 oder 2, wobei
die Drain-Elektroden (2a) und die Source-Elektroden (2) eine längliche Form aufweisen, wobei die Längsachsen (7) der Drain-Elektrode (2a) und der Source-Elektrode (2) eines Paars parallel zueinander angeordnet sind.

4. Substrat nach einem der vorhergehenden Ansprüche, wobei die größte Größe (D) der Halbleiterelemente (6) des Musters (12) zumindest 50% größer als der kleinste Abstand (L) zwischen der Drain-Elektrode (2a) und der Source-Elektrode (2) eines Paars ist.

5. Substrat nach einem der vorhergehenden Ansprüche, wobei die größte Größe (D) der Halbleiterelemente (6) des Musters (12) zumindest 100% größer als der kleinste Abstand (L) zwischen der Drain-Elektrode (2a) und der Source-Elektrode (2) eines Paars ist.

6. Substrat nach einem der vorhergehenden Ansprüche, wobei der kleinste Abstand (M) zwischen Elektroden (2, 2a) benachbarter Paare zumindest 200% größer als der kleinste Abstand (L) zwischen der Drain-Elektrode (2a) und der Source-Elektrode (2) eines Paars ist.

7. Substrat nach einem der vorhergehenden Ansprüche, wobei die Halbleiterelemente (6) des Musters (12) kreisförmig sind.

8. Substrat nach einem der vorhergehenden Ansprüche, wobei die Halbleiterelemente (6) des Musters (12) in einer Sechseckform angeordnet sind.

9. Substrat nach Anspruch 8, wobei
die Sechsecke (21) des Musters (12) um 15° bezüglich der Längsachsen (7) der Drain-Elektroden (2a) und der Source-Elektroden (2) geneigt sind.

10. Verfahren zur Herstellung eines Substrats (5), aufweisend eine Vielzahl organischer Dünnschichttransistoren, wobei jeder Transistor eine Drain-Elektrode (2a), eine Source-Elektrode (2), eine Gate-Elektrode (4) und einen Kanal (11) aus Halbleitermaterial (1), der die Drain-Elektrode (2a) und die Source-Elektrode (2) verbindet, aufweist,
aufweisend die Schritte der Ausbildung einer Vielzahl von Paaren von Drain-Elektroden (2a) und Source-Elektroden (2) auf dem Substrat (5), wobei der kleinste Abstand (L) zwischen der Drain-Elektrode (2a) und der Source-Elektrode (2) eines Paars kleiner als der kleinste Abstand (M) zwischen Elektroden (2, 2a) benachbarter Paare oder zwischen Elektroden (2, 2a) und anderen leitenden Leitungen des Substrats (5) ist,
wobei
der Kanal (11) des Halbleitermaterials (1) der Vielzahl von Dünnschichttransistoren durch Aufbringen eines regelmäßigen Musters (12) von Halbleiterelementen (6) aus Halbleitermaterial (1) ausgebildet wird, wobei die größte Größe (D) der Halbleiterelemente (6) des Musters (12) kleiner als der kleinste Abstand (M) zwischen Elektroden (2, 2a) benachbarter Paare, jedoch zumindest gleich dem kleinsten Abstand (M) zwischen der Drain-Elektrode (2a) und der Source-Elektrode (2) eines Paars ist.

11. Verfahren nach Anspruch 10, wobei
die Kanäle aus Halbleitermaterial (1) der Vielzahl von Dünnschichttransistoren durch Aufbringen eines sechseckförmigen Musters (12) ausgebildet werden, wobei die Halbleiterelemente (6) des Musters (12) kreisförmig sind.

12. Verfahren nach Anspruch 10 oder 11, wobei
das Aufbringen des Musters (12) durch die Abscheidung von Halbleitermaterial (1) durch eine Schattenmaske (13) durchgeführt wird.

13. Verfahren nach Anspruch 12, wobei
die Schattenmaske (13), die ein sechseckförmiges Muster (12) aufweist, verwendet und derart angeordnet wird, dass die Sechsecke (21) der Schattenmaske (13) um 15° bezüglich der Längsachsen (7) der Drain-Elektroden (2a) und der Source-Elektroden (2) geneigt sind.

14. Verfahren nach Anspruch 10 oder 11, wobei
das Aufbringen des Musters (12) durch die Abscheidung von Halbleitermaterial (1) durchgeführt wird, wobei ein Muster aus Tröpfchen ohne Ausrichtungsverfahren oder lokale Registration gedruckt wird.

15. Verfahren nach Anspruch 14, wobei
Tintenstrahldruck zum Drucken des Musters aus Tröpfchen verwendet wird und ein sechseckförmiges Muster (12) aufgebracht und derart angeordnet wird, dass die Sechsecke (21) des Musters (12) um 15° bezüglich der Längsachsen (7) der Drain-Elektroden (2a) und der Source-Elektroden (2) geneigt sind.

16. Schattenmaske (13) zum Aufbringen von Halbleitermaterial (1) nach dem Verfahren nach einem der Ansprüche 10 bis 15 für eine Vielzahl organischer Dünnschichttransistoren, wobei die Schattenmaske (13) ein sechseckförmiges Muster (12) aufweist,
wobei
die Schattenmaske (13) eine Rechteckform aufweist, wobei die Rechtecke (21) des Musters (12) der Schattenmaske (13) um 15° bezüglich eines der Ränder (9, 10) der Schattenmaske (13) geneigt sind.

## Revendications

1. Substrat (5), comprenant une pluralité de paires d'électrodes de drain (2a) et d'électrodes de source (2) pour des transistors à film mince organiques, grâce à quoi la distance minimale (L) entre une électrode de drain (2a) et une électrode de source (2) d'une paire est inférieure à la distance minimale (M) entre des électrodes (2, 2a) de paires adjacentes, ou entre des électrodes (2, 2a) et d'autres lignes conductrices du substrat (5),
dans lequel :
le substrat (5) comprend un motif régulier (12) d'éléments semiconducteurs (6) en matériau semiconducteur (1), pour chacune des paires, certains éléments semiconducteurs (6) connectant l'électrode de drain (2a) et l'électrode de source (2) de la paire, d'autres éléments semiconducteurs venant en contact avec une seule de l'électrode de drain (2a) et de l'électrode de source (2) de la paire, la dimension maximale (D) des éléments semiconducteurs (6) du motif (12) étant inférieure à la distance minimale (M) entre des électrodes (2, 2a) de paires adjacentes, mais au moins égale à la distance minimale (L) entre une électrode de drain (2a) et une électrode de source (2) d'une paire.

2. Substrat (5), comprenant une pluralité de transistors à film mince organiques, chaque transistor comprenant une électrode de drain (2a), une électrode de source (2), une électrode de grille (4) et un canal (11) de matériau semiconducteur (1) connectant l'électrode de drain (2a) et l'électrode de source (2), grâce à quoi la distance minimale (L) entre une électrode de drain (2a) et une électrode de source (2) d'un transistor est inférieure à la distance minimale (M) entre des électrodes (2, 2a) de transistors adjacents, ou entre des électrodes (2, 2a) et d'autres lignes conductrices du substrat (5),
dans lequel :
le canal (11) de matériau semiconducteur (1) des transistors à film mince est formé par un motif régulier (12) d'éléments semiconducteurs (6) en matériau semiconducteur (1), la dimension maximale (D) des éléments semiconducteurs (6) du motif (12) étant inférieure à la distance minimale (M) entre des électrodes (2, 2a) de paires adjacentes, mais au moins égale à la distance minimale (L) entre une électrode de drain (2a) et une électrode de source (2) d'une paire.

3. Substrat selon la revendication 1 ou 2, dans lequel :
les électrodes de drain (2a) et les électrodes de source (2) comprennent une forme allongée dans laquelle les axes longitudinaux (7) de l'électrode de drain (2a) et de l'électrode de source (2) d'une paire sont disposés parallèlement l'un à l'autre.

4. Substrat selon l'une des revendications précédentes, dans lequel :
la dimension maximale (D) des éléments semiconducteurs (6) du motif (12) est supérieure d'au moins 50% à la distance minimale (L) entre une électrode de drain (2a) et une électrode de source (2) d'une paire.

5. Substrat selon l'une des revendications précédentes, dans lequel :
la dimension maximale (D) des éléments semiconducteurs (6) du motif (12) est supérieure d'au moins 100% à la distance minimale (L) entre une électrode de drain (2a) et une électrode de source (2) d'une paire.

6. Substrat selon l'une des revendications précédentes, dans lequel :
la distance minimale (M) entre des électrodes (2, 2a) de paires adjacentes est supérieure d'au moins 200% à la distance minimale (L) entre une électrode de drain (2a) et une électrode de source (2) d'une paire.

7. Substrat selon l'une des revendications précédentes, dans lequel :
les éléments semiconducteurs (6) du motif (12) sont de forme circulaire.

8. Substrat selon l'une des revendications précédentes, dans lequel :
les éléments semiconducteurs (6) du motif (12) sont agencés selon une forme d'hexagone.

9. Substrat selon la revendication 8, dans lequel :
les hexagones (21) du motif (12) sont inclinés de 15° par rapport aux axes longitudinaux (7) d'électrodes de drain (2a) et d'électrodes de source (2).

10. Procédé pour produire un substrat (5) comprenant une pluralité de transistors à film mince organiques, chaque transistor comprenant une électrode de drain (2a), une électrode de source (2), une électrode de grille (4) et un canal (11) de matériau semiconducteur (1) connectant l'électrode de drain (2a) et l'électrode de source (2),
comprenant les étapes de formation d'une pluralité de paires d'électrodes de drain (2a) et d'électrodes de source (2) sur le substrat (5), grâce à quoi la distance minimale (L) entre une électrode de drain (2a) et une électrode de source (2) d'une paire est inférieure à la distance minimale (M) entre des électrodes (2, 2a) de paires adjacentes, ou entre des électrodes (2, 2a) et d'autres lignes conductrices du substrat (5),
dans lequel :
le canal (11) de matériau semiconducteur (1) de la pluralité de transistors à film mince est formé par l'application d'un motif régulier (12) d'éléments semiconducteurs (6) en matériau semiconducteur (1), la dimension maximale (D) des éléments semiconducteurs (6) du motif (12) étant inférieure à la distance minimale (M) entre des électrodes (2, 2a) de paires adjacentes, mais au moins égale à la distance minimale (M) entre une électrode de drain (2a) et une électrode de source (2) d'une paire.

11. Procédé selon la revendication 10, dans lequel :
les canaux de matériau semiconducteur (1) de la pluralité de transistors à film mince sont formés par l'application d'un motif en forme d'hexagone (12), les éléments semiconducteurs (6) du motif (12) étant de forme circulaire.

12. Procédé selon les revendications 10 ou 11, dans lequel :
l'application du motif (12) est effectuée par déposition de matériau semiconducteur (1) à l'aide d'un masque de gravure (13).

13. Procédé selon la revendication 12, dans lequel :
le masque de gravure (13) ayant un motif en forme d'hexagone (12) est utilisé et agencé de telle sorte que les hexagones (21) du masque de gravure (13) soient inclinés de 15° par rapport aux axes longitudinaux (7) d'électrodes de drain (2a) et d'électrodes de source (2).

14. Procédé selon les revendications 10 ou 11, dans lequel :
l'application du motif (12) est effectuée par déposition de matériau semiconducteur (1) avec l'impression d'un motif de gouttelettes sans procédure d'alignement ni alignement local.

15. Procédé selon la revendication 14, dans lequel :
une impression à jet d'encre est utilisée pour imprimer le motif de gouttelettes et un motif en forme d'hexagone (12) est appliqué et agencé de telle sorte que les hexagones (21) du motif (12) soient inclinés de 15° par rapport aux axes longitudinaux (7) d'électrodes de drain (2a) et d'électrodes de source (2).

16. Masque de gravure (13) pour l'application de matériau semiconducteur (1) selon le procédé de l'une des revendications 10 à 15 pour une pluralité de transistors à film mince organiques, le masque de gravure (13) comprenant un motif en forme d'hexagone (12),
dans lequel :
le masque de gravure comprend une forme rectangulaire, les hexagones (21) du motif (12) du masque de gravure (13) étant inclinés de 15° par rapport à l'un des bords (9, 10) du masque de gravure (13).
